# EUROPÄISCHE PATENTSCHRIFT

(11) **EP 0 919 114 B1**
(45) Veröffentlichungstag und Bekanntmachung des Hinweises auf die Patenterteilung: **19.01.2011**
(21) Anmeldenummer: 97933819.1
(22) Anmeldetag: 18.08.1997
(51) Int. Cl.: H05K 9/00

(54) **VERFAHREN ZUM ABSCHIRMEN EINER ELEKTRISCHEN ODER ELEKTRONISCHEN SCHALTUNG SOWIE ABSCHIRMKAPPE**
PROCESS FOR SHIELDING AN ELECTRIC OR ELECTRONIC CIRCUIT AND SHIELDING CAP
PROCEDE POUR BLINDER UN CIRCUIT ELECTRIQUE OU ELECTRONIQUE, ET CAPOT DE BLINDAGE

(30) Priorität: 18.08.1996 DE 19634174
(43) Veröffentlichungstag der Anmeldung: 02.06.1999
(60) Teilanmeldung: 10166607.1
(73) Patentinhaber: Kahl, Helmut, 12307 Berlin (DE); Tiburtius, Bernd, 14532 Kleinmachnow (DE)
(72) Erfinder: Kahl, Helmut, 12307 Berlin (DE); Tiburtius, Bernd, 14532 Kleinmachnow (DE)
(74) Vertreter: Ottow, Jens M.
(86) Internationale Anmeldenummer: PCT/IB1997/001001
(87) Internationale Veröffentlichungsnummer: WO 1998/008365

(56) Entgegenhaltungen:
- EP-A- 0 643 551
- EP-A- 0 643 552
- EP-A- 0 806 891
- EP-A- 0 892 502
- EP-A- 1 198 164
- EP-A1- 0 407 072
- EP-A1- 0 702 512
- EP-A1- 0 726 700
- EP-A2- 0 262 332
- EP-A2- 0 519 767
- EP-B1- 0 976 311
- WO-A-96/22672
- WO-A-98/23139
- WO-A-98/49880
- WO-A-99/34659
- DE-U- 6 607 180
- DE-U- 9 404 291
- DE-U1- 29 515 035
- DE-U1- 29 602 025
- GB-A- 2 300 761
- JP-A- 5 007 177
- US-A- 4 370 515
- US-A- 4 890 199
- US-A- 5 014 160
- US-A- 5 508 889
- US-A- 5 717 577
- US-A- 5 847 938
- PATENT ABSTRACTS OF JAPAN vol. 095, no. 011, 26.Dezember 1995 & JP 07 221482 A (MATSUSHITA ELECTRIC IND CO LTD), 18.August 1995,
- PATENT ABSTRACTS OF JAPAN vol. 015, no. 428 (E-1128), 30.Oktober 1991 & JP 03 179799 A (MATSUSHITA ELECTRIC IND CO LTD), 5.August 1991,

## Beschreibung

### TECHNISCHES GEBIET

Die vorliegende Erfindung bezieht sich auf das Gebiet der elektromagnetischen Abschirmtechnik. Sie betrifft ein Verfahren zum Abschirmen einer elektrischen oder elektronischen Schaltung gegen die Aufnahme und/oder Abgabe elektromagnetischer Störstrahlung, bei welchem Verfahren eine elektrisch leitende Abschirmkappe an einer Aufsetzfläche mit einer über die Aufsetzfläche hinausstehenden elastischen und elektrisch leitenden Abschirmdichtung versehen und anschliessend mit der Abschirmdichtung auf eine die Schaltung umgebende, elektrisch leitende Umrahmung aufgesetzt und fixiert wird.

Die Erfindung betrifft weiterhin eine Abschirmkappe zum Abschirmen einer elektrischen oder elektronischen Schaltung gegen die Aufnahme und/oder Abgabe elektromagnetischer Störstrahlung, welche Abschirmkappe eine Aufsetzfläche zum Aufsetzen der Abschirmkappe auf eine die Schaltung umgebende, elektrisch leitende Umrahmung aufweist, und an der Aufsetzfläche mit einer über die Aufsetzfläche hinausstehenden elastischen und elektrisch leitenden Abschirmdichtung versehen ist.

Ein solches Verfahren und eine solche Abschirmkappe sind z.B. aus dem Deutschen Gebrauchsmuster G66071805 bekannt.

### STAND DER TECHNIK

Zur elektromagnetischen Abschirmung von elektronischen Schaltungen oder Schaltungsteilen gegen die Aufnahme und/oder Abgabe von insbesondere höherfrequenten elektromagnetischen Störfeldern werden die Schaltungen bzw. Schaltungsteile mit einer elektrisch leitenden becher- oder wannenförmigen Abschirmkappe abgedeckt. Die Abschirmkappe wird dazu mit ihren Rand bzw. mit einer Aufsetzfläche auf eine elektrisch leitende Umrahmung aufgesetzt, welche die Schaltung umgibt und fixiert. Die Umrahmung kann beispielsweise eine Kupferschicht sein, welche auf der Oberseite der Leiterplatte, welche die Schaltung trägt, angeordnet ist.

Problematisch ist bei der Anwendung von Abschirmkappen einerseits ein gleichmässig guter, sich über den gesamten Rand der Kappe erstreckender, elektrischer Kontakt zwischen Abschirmkappe und Umrahmung, und andererseits die sichere Befestigung der Abschirmkappe in der Abschirmposition. Um eine Anpassung der Aufsetzfläche der Abschirmkappe an Unebenheiten in der Umrahmung zu ermöglichen und so unerwünschte Löcher in der Abschirmung zu verhindern, kann der Rand der Abschirmkappe z.B. federnd ausgebildet oder über einen Kontaktfederstreifen mit der Umrahmung in Verbindung stehen. Weiterhin ist in der eingangs genannten Druckschrift vorgeschlagen worden, für den Uebergang zwischen Aufsetzfläche und Umrahmung eine elektrisch leitende, elastisch verformbare Abschirmdichtung einzusetzen. Umfasst die Abschirmung einen Deckel, besteht die Abschirmdichtung aus einer flachen Schaumstoffschicht auf der Unterseite des Deckels, die entweder durch leitende Beimengungen (Kohle- oder Metallpulver) selbst elektrisch leitend ist oder durch Aufdampfen von Metall oder Aufkleben einer Metallfolie elektrisch leitend gemacht wird. Umfasst die Abschirmung eine Abschirmkappe, ist am Rand der Kappe eine Nut ausgebildet, in welcher ein umlaufender Ring aus Schaumstoff eingelagert ist, der wiederum entweder selbst elektrisch leitend oder durch Oberflächenbeschichtung elektrisch leitend gemacht worden ist. Zur Ausbildung der Nut wird an dem hochgezogenen Rand der Abschirmkappe auf der Innenseite ein Profilblech mittels Punktschweissung befestigt. Die Ausbildung einer derartigen Nut erfordert nicht nur einen erheblichen Mehraufwand bei der Herstellung der Abschirmkappe, sondern beansprucht auch zusätzlichen Platz. Darüber hinaus kann die Nut bei komplizierteren, verwinkelten Geometrien der Abschirmkappe nur schwer hergestellt werden.

### DARSTELLUNG DER ERFINDUNG

Es ist daher Aufgabe der Erfindung, ein Verfahren zur Abschirmung einer elektrischen oder elektronischen Schaltung sowie eine Abschirmkappe anzugeben, welche sich bei sehr guten Abschirmergebnissen durch grosse Einfachheit und hohe Flexibilität in der Anwendung auszeichnen.

Die Aufgabe wird bei einem Verfahren der eingangs genannten Art durch die Merkmale aus dem kennzeichen des Anspruchs 1 gelöst.

Durch das erfindungsgemäss direkte Aufbringen der Dichtungsmasse auf die Aufsetzfläche wird das Ausbilden einer Nut oder anderer spezieller Aufnahmen für die Dichtung überflüssig. Dies ist besonders von Vorteil, wenn die Aufsetzfläche der Abschirmkappe einfach kantenförmig ausgebildet ist. Die Dichtungsmasse wird dem (möglicherweise komplizierten) Kantenverlauf folgend direkt auf die Stirnseite der Kante aufgebracht und dort klebend verankert. Hierdurch wird mit einem Minimum an Platzverbrauch und Einsatz an (teurer) Dichtungsmasse eine optimale Abschirmdichtung für die Abschirmkappe bereitgestellt.

Grundsätzlich könnte die Dichtungsmasse mittels einer Dispensiereinrichtung durch eine Düse in Form wenigstens eines Stranges auf die Aufsetzfläche aufgebracht werden. Mittels eines derartiges Auftragverfahrens, wie es in einem anderen Zusammenhang, nämlich für abschirmende Gehäuse, z.B. aus der DE-C2-43 19 965 bekannt ist, kann die pastöse oder leicht flüssige Dichtungsmasse in genauer Dosierung und mit vorgegebener Querschnittsform direkt auf die Kante der Abschirmkappe aufgebracht werden. Bei entsprechender Steuerung (Programmierung) der in drei Achsen verfahrbaren Dispensiereinrichtung können auch komplizierte Randgeometrien der Abschirmkappe nachgefahren werden. Die Eigenschaften der Dichtungsmasse sollten dabei zweckmässigerweise so eingestellt sein, dass der auf die Kante aufgebrachte Strang aus Dichtungsmasse auf der Kante aushärtet, ohne zu verlaufen. Auch könnten zur Bildung der Abschirmdichtung mehrere Dichtungsstränge übereinander aufgebracht werden. Durch die hierdurch erzielte grössere Höhe der Abschirmdichtung lassen sich entsprechend grössere Toleranzen zwischen Umrahmung und Aufsetzfläche ausgleichen.

Gemäss der Erfindung wird jedoch die Dichtungsmasse dadurch auf die Aufsetzfläche aufgebracht, dass eine fliessfähige Dichtungsmasse verwendet wird, und dass die Abschirmkappe mit der Aufsetzfläche in ein Bad aus der Dichtungsmasse eingetaucht und anschliessend wieder herausgezogen wird. Die Dichtungsmasse benetzt die Kante bzw. Aufsetzfläche der Abschirmkappe und bildet autgrund der Oberflächenspannung beim Herausziehen einen die Kante umgebenden Wulst, der (nach dem Aushärten) eine umlaufende Abschirmdichtung bildet. Der Vorteil besteht darin, dass auf schnelle und einfache Weise und ohne Einsatz einer numerisch gesteuerten Auftrag-und Dosiervorrichtung die gesamte Kante gleichzeitig mit der Abschirmdichtung versehen wird. Die Dicke der sich bildenden Abschirmdichtung wird dabei massgeblich von den Eigenschaften der Dichtungsmasse im Bad bestimmt und kann möglicherweise auch dadurch beeinflusst werden, dass der Eintauchvorgang mehrmals wiederholt wird. handelt es sich bei der Dichtungsmasse um ein bei Luftfeuchtigkeit aushärtendes (vernetzendes) Material, sollte der Eintauchvorgang unter einer Schutzgasatmosphäre durchgeführt werden.

Bevorzugt wird als Dichtungsmasse ein elektrisch leitender Elastomer, insbesondere auf Silikon- oder Polyurethanbasis verwendet, welcher elektrisch leitende Füllstoffe enthält. Hierdurch wird die Abschirmdichtung ohne zusätzliche Schritte direkt durch Auftragen der Dichtungsmasse erzeugt. Beispielhafte Zusammensetzungen derartiger Dichtungsmassen können u.a. den Europäischen Patentanmeldungen Nr. 0 643 551 und 0 643 552 entnommen werden.

Die Fixierung der aufgesetzten Abschirmkappe kann im Rahmen der Erfindung auf verschiedene Weise erfolgen. Gemäss einem bevorzugten Ausführungsbeispiel wird die Abschirmkappe nach dem Aufsetzen auf die Umrahmung mechanisch fixiert, wobei zur mechanischen Fixierung vorzugsweise Hilfsmittel verwendet werden, welche die Abschirmkappe mit der Abschirmdichtung gegen die Umrahmung drücken. Die Hilfsmittel umfassen dabei insbesondere einen Federbügel, eine Schraube, ein gegenüberliegendes Gehäuseteil oder Federbleche, die an der Abschirmkappe angebracht sind, insbesondere Teil einer aus Metallblech hergestellten Abschirmkappe sind.

Gemäss einem anderen bevorzugten Ausführungsbeispiel haftet die Abschirmkappe nach dem Aufsetzen auf die Umrahmung mit der Abschirmdichtung auf der Umrahmung klebend. Dies kann einerseits dadurch erreicht werden, dass als Dichtungsmasse ein elektrisch leitender Elastomer verwendet wird, welcher eine klebrige bzw. nasse Konsistenz aufweist und durch Temperatur oder Strahlung aushärtbar ist, und nach dem Aufsetzen der Abschirmkappe auf die Umrahmung ausgehärtet wird, oder dass ein elektrisch leitender Elastomer verwendet wird, welcher eine auch nach dem Aushärten noch eine klebrige bzw. nasse Konsistenz aufweist. Dies kann andererseits aber auch dadurch erreicht werden, dass als Dichtungsmasse ein elektrisch leitender Thermoplast oder ein elektrisch leitender Schmelzkleber verwendet wird, und dass die Abschirmkappe nach dem Aufsetzen auf die Umrahmung durch Erhöhung der Temperatur auf die Umrahmung geklebt wird.

Die erfindungsgemässe Abschirmkappe ist durch die Merkmale des Anspruchs 14 bestimmt.

Eine bevorzugte Ausführungsform der Abschirmkappe nach der Erfindung ist **dadurch gekennzeichnet, dass** die Aufsetzfläche kantenförmig ausgebildet ist, und dass entweder die Abschirmdichtung auf die Stirnseite der Kante aufgesetzt ist, oder dass die Abschirmdichtung die Kante umschliesst.

Weitere Ausführungsformen ergeben sich aus den abhängigen Ansprüchen.

### KURZE ERLÄUTERUNG DER FIGUREN

Die Erfindung soll nachfolgend anhand von Ausführungsbeispielen im Zusammenhang mit der Zeichnung näher erläutert werden. Es zeigen
- Fig. 1: eine beispielhafte Schaltung auf einer Leiter- platte ohne Abschirmkappe in der Draufsicht (Fig. 1a) und mit gestrichelt eingezeichneter Abschirm- kappe in der Seitenansicht (Fig. 1b);
- Fig. 2: die Abschirmkappe aus Fig. 1b in perspektivischer Ansicht (mit Oeffnung nach unten);

- Fig. 3-5: in der Seitenansicht verschiedene beispielhafte Arten der Befestigung der Abschirmkappe im Rahmen der Erfindung, nämlich mittels einen klebenden Abschirmdichtung (Fig. 3), durch einem Federbügel und/oder eine Schraube (Fig. 4), und durch Ab- stützen an einem gegenüberliegenden Gehäuseteil oder dgl. (Fig. 5);
- Fig. 6a-c: verschiedene Schritte beim Erzeugen der Ab- schirmdichtung durch Eintauchen der Abschirmkappe in ein Bad aus der (flüssigen) Dichtungsmasse ge- mäss der Erfindung;
- Fig. 7: in Schnitt eine Art der Abschirmdich- tung nach der Erfindung, die durch Eintauchen ge- mäss Fig. 6 hergestellt worden ist.

### WEGE ZUR AUSFÜHRUNG DER ERFINDUNG

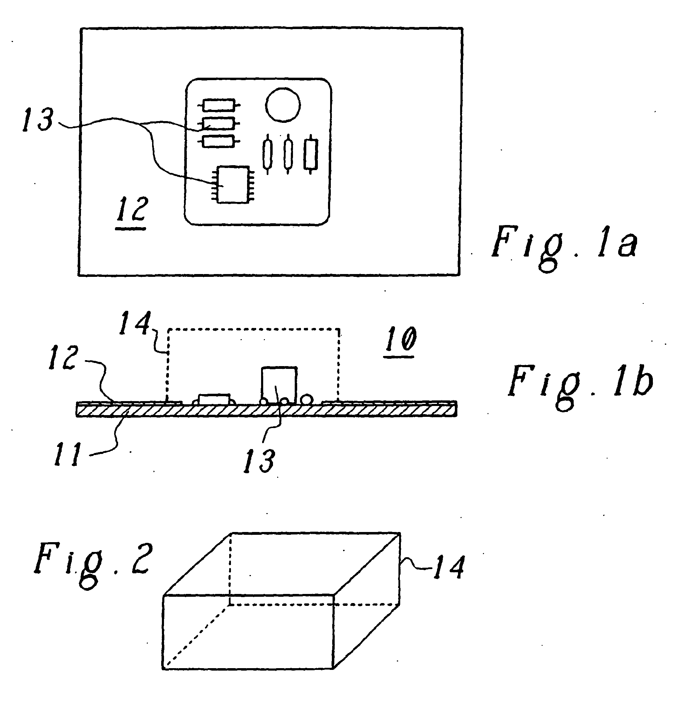

In Fig. 1 ist eine beispielhafte Schaltung auf einer Leiterplatte ohne Abschirmkappe in der Draufsicht (Fig. 1a) und in der Seitenansicht (Fig. 1b) wiedergegeben. Die Schaltung 10 umfasst eine Leiterplatte 11 (gedruckte Schaltung oder Multilayer), auf welcher in einem zentralen Bereich mehrere elektronische Bauelemente 13 (Widerstände, Kondensatoren, Dioden, ICs etc.) angeordnet und miteinander verschaltet sind. Die Bauelemente 13 bilden eine Teilschaltung, die gegenüber anderen Teilschaltungen oder der Umwelt abgeschirmt werden soll, damit keine elektromagnetischen Störfelder von der Teilschaltung nach aussen abgegeben oder von aussen aufgenommen werden. Die Teilschaltung ist dazu von einer leitenden Umrahmung 12 in Form einer oberseitigen Metallisierung der Leiterplatte 11 umgeben. Es versteht sich von selbst, dass Teilschaltung, Umrahmung 12 und Aufbau der Schaltung 10 auch eine andere Form und Gestaltung aufweisen können.

Die Abschirmung der Teilschaltung mit den Bauelementen 13 erfolgt durch eine becherfömige Abschirmkappe 14 (in Fig. 1b gestrichelt eingezeichnet), die in Fig. 2 in perspektivischer Ansicht gezeigt ist. Die Abschirmkappe 14 hat im gezeigten Beispiel die Form eines rechteckigen Kastens. Selbstverständlich kann die Abschirmkappe aber auch rund sein oder schiefwinklig, und Ausbuchtungen, Vorsprünge o.ä. aufweisen. Die Abschirmkappe 14 kann aus einem Blech gebogen, gelötet oder geformt (tiefgezogen) sein; sie kann aber auch aus metallisiertem Kunststoff bestehen. Die Abschirmkappe 14 wird - wie in Fig. 1b angedeutet - über die Teilschaltung "gestülpt". Der die offene Seite der Abschirmkappe 14 begrenzende Rand (die Kante) bildet eine Aufsetzfläche und liegt auf der Umrahmung 12 auf, um einen dichten und elektrisch leitenden Uebergang von der Abschirmkappe 14 zur Umrahmung 12 herzustellen.

Zum Ausgleich von Unebenheiten wird nun zwischen dem Rand bzw. der Aufsetzfläche der Abschirmkappe 14 und der Umrahmung 12 eine elastische und elektrisch leitende Abschirmdichtung vorgesehen, die den elektrischen Kontakt zwischen der Abschirmkappe 14 und der Umrahmung 12 vermittelt und in der Lage ist, Toleranzen von mehreren 1/10 Millimetern auszugleichen.

Als Dichtungsmasse 21 wird vorzugsweise ein elektrisch leitender Elastomer auf Silikon- oder Polyurethanbasis verwendet, welcher elektrisch leitende Füllstoffe enthält,

Die Dichtungsmasse 21 kann sowohl eine feste als auch eine plastische oder klebrige Konsistenz aufweisen. Sie kann direkt durch Luftfeuchtigkeit aushärtbar bzw. vernetzbar sein, wenn ein Festkleben der Abschirmkappe 14 auf der Umrahmung 12 nicht unbedingt beabsichtigt ist. Sie kann aber auch durch Wärme oder Strahlung (UV-, IR-, Röntgen- oder Laserstrahlung) vernetzbar sein, wenn z.B. die Abschirmkappe 14 mit der Abschirmdichtung auf die Umrahmung 12 geklebt werden soll. Die Aushärtung wird in diesem Fall erst vorgenommen, wenn die Abschirmkappe 14 bereits aufgesetzt ist. Wird eine Dichtungsmasse verwendet, die auch nach dem Aushärten noch klebrig ist, kann die Abschirmkappe auch nach dem Aushärten aufgeklebt werden. Alternativ dazu ist es aber auch denkbar, dass als Dichtungsmasse ein elektrisch leitender Thermoplast oder ein elektrisch leitender Schmelzkleber verwendet wird, und dass die Abschirmkappe 14 nach dem Aufsetzen auf die Umrahmung 12 durch eine entsprechende Erhöhung der Temperatur auf die Umrahmung 12 geklebt wird. Ebenso können als Dichtungsmasse 21 aber auch elektrisch leitende oder isotrope Kunststoffe verwendet werden.

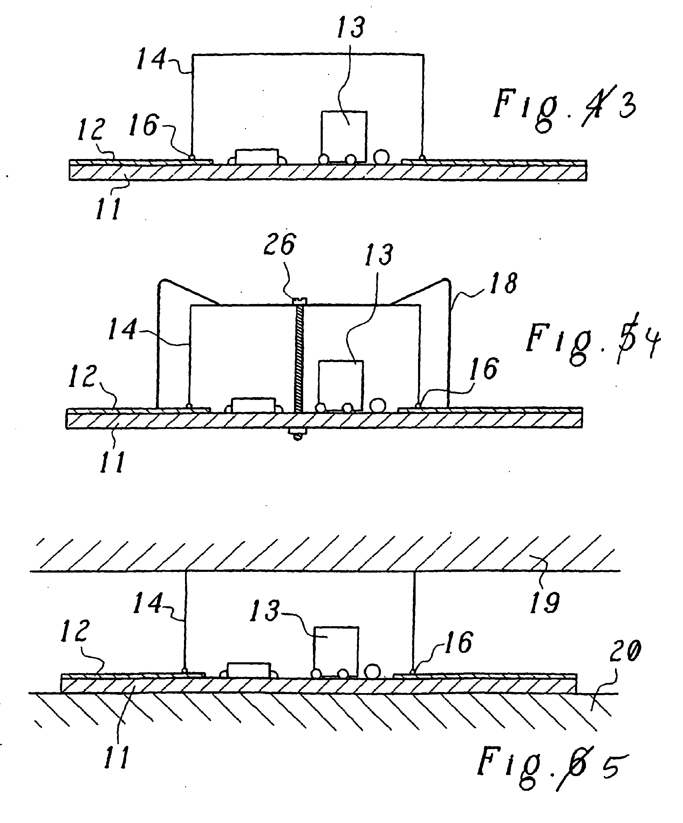

Wird als Dichtungsmasse 21 eine Masse aufgebracht, die aufgrund ihrer Eigenschaften ein direktes Aufkleben der Abschirmkappe 14 auf die Umrahmung zulässt, kann die mit der Abschirmdichtung 16 versehene Abschirmkappe 14 direkt auf die Umrahmung 12 aufgesetzt und festgeklebt werden (Fig. 3). Reicht die Klebekraft für eine dauerhafte Fixierung der Abschirmkappe 14 aus, kann auf zusätzliche Fixierungs-Hilfsmittel in diesem Fall verzichtet werden, was die Anwendung stark vereinfacht. Reicht die Klebkraft dagegen nicht aus oder ist eine Klebewirkung der Abschirmdichtung gar nicht vorhanden, werden zur Fixierung der Abschirmkappe 14 zusätzliche (überwiegend mechanische) Hilfsmittel eingesetzt. Im Beispiel der Fig. 4 wird ein Federbügel 18 eingesetzt, der mit seinen Enden an der Leiterplatte 11 befestigt ist, und mit seinem federnden Mittelteil von oben auf die Abschirmkappe 14 drückt. Anstelle des Federbügels 18 kommen auch Klammern oder ähnliche Halteelemente in Betracht. Weiterhin kann anstelle des Federbügels 18 oder zusätzlich zum Federbügel 18 als Hilfsmittel auch eine (oder mehrere) Schraube(n) 26 verwendet werden, die entweder durch ein Loch in der Abschirmkappe 14 gesteckt und mit der Leiterplatte 11 verschraubt, oder umgekehrt durch ein Loch in der Leiterplatte 11 gesteckt und mittels eines Inserts mit der Abschirmkappe 14 verschraubt wird (werden). Eine weitere Möglichkeit der Fixierung zeigt Fig. 5. Hier wird ein gegenüberliegendes Gehäuseteil 19 oder dgl. ausgenützt, um die Abschirmkappe 14 gegen die Leiterplatte 11 zu drücken, die sich ihrerseits auf einer Unterlage 20 abstützt.

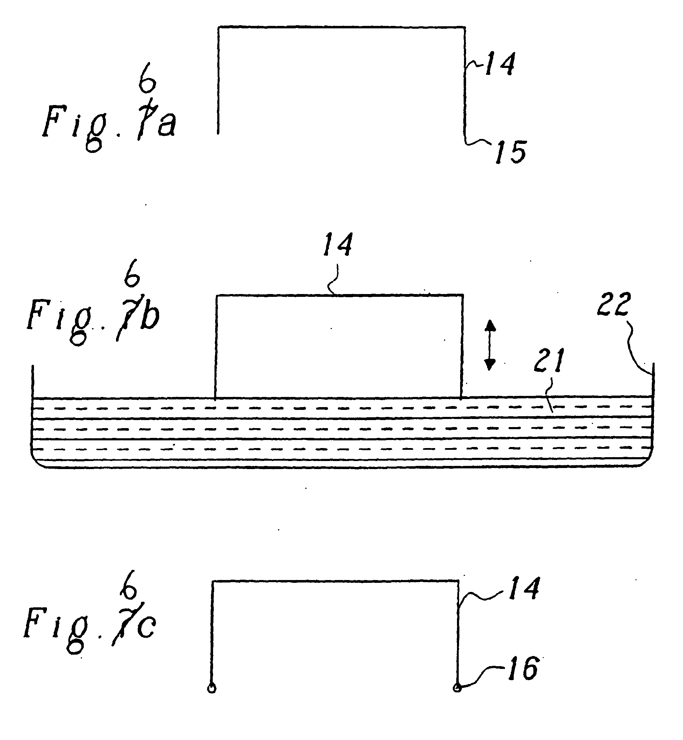

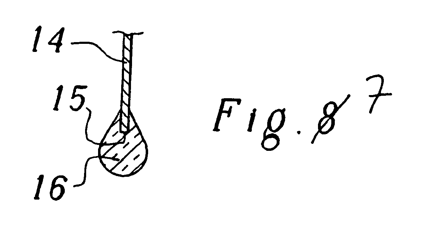

Das Aufbringen der Abschirmdichtung 16 mittels einer Dispensiereinrichtung erfordert entsprechende apparative Einrichtungen. Darüber hinaus muss die numerische Steuerung der Dispensiereinrichtung durch Programmieren auf den Kantenverlauf der jeweiligen Abschirmkappe 14 eingestellt werden. Der apparative Aufwand kann demgegenüber deutlich verringert werden, wenn zum Aufbringen der Abschirndichtung auf die Aufsetzfläche 15 der Abschirmkappe 14 das erfindungsgemasse Verfahren ("Einitauchverfahren") verwendet wird, welches beispielhaft und schematisch in Fig. 6 dargestellt ist. Bei dem Eintauchverfahren wird die Abschirmkappe 14 mit der Oeffnung bzw. der Aufsetzfläche 15 nach unten (Fig. 6a) in ein Bad mit einer flüssigen oder zähflüssigen Dichtungsmasse 21 eingetaucht (Fig. 6b). Die in einem Behälter 22 befindliche Dichtungsmasse 21 hat dabei einen möglichst ebenen Flüssigkeitsspiegel. Wird nun die Abschirmkappe 14 mit dem Rand langsam und gleichmässig einige 1/10 Millimeter in die Dichtungsmasse 21 eingetaucht, benetzt die Dichtungsmasse 21 den Rand. Beim Herausziehen der Abschirmkappe 14 aus dem Bad bildet sich aufgrund der Oberflächenspannung um die Kante der Kappe ein ringförmiger Wulst aus Dichtungsmasse, der nach dem Aushärten eine fest mit der Kante verbundene Abschirmdichtung 16 bildet (Fig. 6c; siehe Schnitt in Fig. 7).

Auf diese Weise kann mit sehr einfachen Mitteln in einem einzigen Vorgang der gesamte Rand der Abschirmkappe 14 mit einer sehr gleichmässig ausgebildeten Abschirmdichtung versehen werden. Die Eigenschaften der Dichtungsmasse (im flüssigen, unvernetzten Zustand) müssen dabei so eingestellt sein, dass das Benetzungsverhalten und Oberflächenspannung die gewünschten Ergebnisse erbringen. Es sei an dieser Stelle noch angemerkt, dass für das Eintauchverfahren die Aufsetzfläche 15 der Abschirmkappe 14 zweckmässigerweise in einer Ebene liegen sollte.

Das Dispensierverfahren ergibt überwiegend einen runden Querschnitt der Abschirmdichtung 16, während das Eintauchverfahren nach Fig. 6 eher zu einem tropfenförmigen Querschnitt gemäss Fig. 7 führt. Soll die Abschirmdichtung 16 grössere Toleranzen ausgleichen, muss ihre Höhe vergrössert werden. Dies kann dadurch erreicht werden, dass die Abschirmdichtung in ihrem Durchmesser vergrössert wird. Dies erfordert jedoch relativ viel zusätzliche teuere Dichtungsmasse.

Insgesamt ergibt sich mit der Erfindung ein Abschirmverfahren bzw. eine Abschirmkappe, die einfach durchzuführen und flexibel in der Anwendung sind, und sich durch einen geringen Fertigungsaufwand bei gleichzeitig hoher Abschirmqualität auszeichnen.

## Patentansprüche

1. Verfahren zum Abschirmen einer elektrischen oder elektronischen Schaltung (10) gegen die Aufnahme und/oder Abgabe elektromagnetischer Störstrahlung, bei welchem Verfahren eine elektrisch leitende Abschirmkappe (14) an einer Aufsetzfläche (15) mit einer über die Aufsetzfläche (15) hinausstehenden elastischen und elektrisch leitenden Abschirmdichtung (16) versehen und anschliessend mit der Abschirmdichtung (16) auf eine die Schaltung (10) umgebende, elektrisch leitende Umrahmung (12) aufgesetzt und fixiert wird, **dadurch gekennzeichnet, dass** die Abschirmdichtung (16) durch direktes Aufbringen einer Dichtungsmasse (21) auf die Aufsetzfläche (15) gebildet wird, dass die Dichtungsmasse (21) **dadurch** auf die Aufsetzfläche (15) aufgebracht wird, dass eine fliessfähige Dichtungsmasse (21) verwendet wird, und dass die Abschirmkappe (14) mit der Aufsetzfläche (15) in ein Bad aus der Dichtungsmasse (21) eingetaucht und anschliessend wieder herausgezogen wird.

2. Verfahren nach Anspruch 1, **dadurch gekennzeichnet, dass** als Dichtungsmasse ein elektrisch leitender Elastomer verwendet wird.

3. Verfahren nach Anspruch 2, **dadurch gekennzeichnet, dass** ein elektrisch leitender Elastomer auf Silikon- oder Polyurethanbasis verwendet wird, welcher elektrisch leitende Füllstoffe enthält.

4. Verfahren nach Anspruch 1, **dadurch gekennzeichnet, dass** als Dichtungsmasse elektrisch leitende oder isotrope Kunststoffe verwendet werden.

5. Verfahren nach einem der Ansprüche 1 bis 4, **dadurch gekennzeichnet, dass** die Abschirmkappe (14) nach dem Aufsetzen auf die Umrahmung (12) mechanisch fixiert wird.

6. Verfahren nach Anspruch 5, **dadurch gekennzeichnet, dass** zur mechanischen Fixierung Hilfsmittel (18, 19, 26, 27, 28) verwendet werden, welche die Abschirmkappe (14) mit der Abschirmdichtung (16) gegen die Umrahmung (12) drücken.

7. Verfahren nach Anspruch 6, **dadurch gekennzeichnet, dass** die Hilfsmittel einen Federbügel (18) umfassen.

8. Verfahren nach Anspruch 6, **dadurch gekennzeichnet, dass** die Hilfsmittel eine Schraube (26) umfassen.

9. Verfahren nach Anspruch 6, **dadurch gekennzeichnet, dass** die Hilfsmittel ein gegenüberliegendes Gehäuseteil (19) umfassen.

10. Verfahren nach einem der Ansprüche 1 bis 9, **dadurch gekennzeichnet, dass** die Abschirmkappe (14) nach dem Aufsetzen auf die Umrahmung (12) mit der Abschirmdichtung (16) auf der Umrahmung (12) klebend haftet.

11. Verfahren nach Anspruch 10, **dadurch gekennzeichnet, dass** als Dichtungsmasse ein elektrisch leitender Elastomer verwendet wird, welcher eine klebrige bzw. nasse Konsistenz aufweist.

12. Verfahren nach Anspruch 11, **dadurch gekennzeichnet, dass** die Dichtungsmasse durch Temperatur oder Strahlung aushärtbar ist und nach dem Aufsetzen der Abschirmkappe (14) auf die Umrahmung (12) ausgehärtet wird.

13. Verfahren nach Anspruch 10, **dadurch gekennzeichnet, dass** als Dichtungsmasse ein elektrisch leitender Thermoplast oder ein elektrisch leitender Schmelzkleber verwendet wird, und dass die Abschirmkappe (14) nach dem Aufsetzen auf die Umrahmung (12) durch Erhöhung der Temperatur auf die Umrahmung (12) geklebt wird.

14. Abschirmkappe (14) zum Abschirmen einer elektrischen oder elektronischen Schaltung (10) gegen die Aufnahme und/oder Abgabe elektromagnetischer Störstrahlung, welche Abschirmkappe (14) eine Aufsetzfläche (15) zum Aufsetzen der Abschirmkappe (14) auf eine die Schaltung (10) umgebende, elektrisch leitende Umrahmung (12) aufweist, und an der Aufsetzfläche (15) mit einer über die Aufsetzfläche (15) hinausstehenden elastischen und elektrisch leitenden Abschirmdichtung (16) versehen ist, **dadurch gekennzeichnet, dass** die Abschirmdichtung (16) aus einer Dichtungsmasse (21) an die Aufsetzfläche (15) durch Eintauchen angeformt ist.

15. Abschirmkappe nach Anspruch 14, **dadurch gekennzeichnet, dass** die Aufsetzfläche (15) kantenförmig ausgebildet ist, und dass die Abschirmdichtung (16) auf die Stirnseite der Kante aufgesetzt ist.

16. Abschirmkappe nach Anspruch 14, **dadurch gekennzeichnet, dass** die Aufsetzfläche (15) kantenförmig ausgebildet ist, und dass die Abschirmdichtung (16) die Kante umschliesst.

17. Abschirmkappe nach einem der Ansprüche 14 bis 16, **dadurch gekennzeichnet, dass** die Abschirmdichtung (16) aus einem elektrisch leitenden Elastomer, insbesondere auf Silikon- oder Polyurethanbasis mit elektrisch leitenden Füllstoffen, besteht.

18. Abschirmkappe nach Anspruch 17, **dadurch gekennzeichnet, dass** derelektrisch leitende Elastomer eine klebrige bzw. nasse Konsistenz aufweist und durch Temperatur oder Strahlung aushärtbar ist.

19. Abschirmkappe nach einem der Ansprüche 14 bis 16, **dadurch gekennzeichnet, dass** die Abschirmdichtung (16) aus einem elektrisch leitenden Thermoplasten oder einem elektrisch leitenden Schmelzkleber besteht.

20. Abschirmkappe nach einem der Ansprüche 14 bis 19, **dadurch gekennzeichnet, dass** sie aus einem metallisierten Isolierstoff besteht.

## Claims

1. Method for screening an electrical or electronic circuit (10) against the reception and/or emission of electromagnetic interference radiation, in which method an electrically conductive screening cap (14) on a fitting surface (15) is provided with an elastic and electrically conductive screening seal (16) which projects beyond the fitting surface (15), and is then fitted and fixed with the screening seal (16) onto an electrically conductive surrounding frame (12), which surrounds the circuit (10), **characterized in that** the screening seal (16) is formed by direct application of a sealing compound (21) to the fitting surface (15), **in that** the sealing compound (21) is applied to the fitting surface (15) by using a sealing compound (21) which can flow, and **in that** the screening cap (14) with the fitting surface (15) is dipped in a bath of the sealing compound (21), and is then pulled out again.

2. Method according to Claim 1, **characterized in that** an electrically conductive elastomer is used as the sealing compound.

3. Method according to Claim 2, **characterized in that** an electrically conductive elastomer is used, which is based on silicone or polyurethane and contains electrically conductive fillers.

4. Method according to Claim 1, **characterized in that** electrically conductive or isotropic plastics are used as the sealing compound.

5. Method according to one of Claims 1 to 4, **characterized in that** the screening cap (14) is mechanically fixed after being fitted to the surrounding frame (12).

6. Method according to Claim 5, **characterized in that** aids (18, 19, 26, 27, 28) which press the screening cap (14) with the screening seal (16) against the surrounding frame (12) are used for mechanical fixing.

7. Method according to Claim 6, **characterized in that** the aids comprise a spring clip (18).

8. Method according to Claim 6, **characterized in that** the aids comprise a screw (26).

9. Method according to Claim 6, **characterized in that** the aids comprise an opposite housing part (19).

10. Method according to one of Claims 1 to 9, **characterized in that**, after being fitted to the surrounding frame (12), the screening cap (14) with the screening seal (16) adheres to the surrounding frame (12).

11. Method according to Claim 10, **characterized in that** an electrically conductive elastomer, which has an adhesive or wet consistency, is used as the sealing compound.

12. Method according to Claim 11, **characterized in that** the sealing compound can be cured by temperature or radiation, and is cured after the screening cap (14) has been fitted to the surrounding frame (12).

13. Method according to Claim 10, **characterized in that** an electrically conductive thermoplastic or an electrically conductive hot-melt adhesive is used as the sealing compound, and **in that**, after being fitted to the surrounding frame (12), the screening cap (14) is adhesively bonded to the surrounding frame (12) by increasing the temperature.

14. Screening cap (14) for screening an electrical or electronic circuit (10) against the reception and/or emission of electromagnetic interference radiation, which screening cap (14) has a fitting surface (15) for fitting the screening cap (14) to an electrically conductive surrounding frame (12) which surrounds the circuit (10), and is provided on the fitting surface (15) with an elastic and electrically conductive screening seal (16) which projects beyond the fitting surface (15), **characterized in that** the screening seal (16) is integrally formed from a sealing compound (21) on the fitting surface (15) by dipping.

15. Screening cap according to Claim 14, **characterized in that** the fitting surface (15) is in the form of an edge, and **in that** the screening seal (16) is fitted to the end face of the edge.

16. Screening cap according to Claim 14, **characterized in that** the fitting surface (15) is in the form of an edge, and **in that** the screening seal (16) surrounds the edge.

17. Screening cap according to one of Claims 14 to 16, **characterized in that** the screening seal (16) is composed of an electrically conductive elastomer, in particular based on silicone or polyurethane with electrically conductive fillers.

18. Screening cap according to Claim 17, **characterized in that** the electrically conductive elastomer has an adhesive or wet consistency and can be cured by temperature or radiation.

19. Screening cap according to one of Claims 14 to 16, **characterized in that** the screening seal (16) is composed of an electrically conductive thermoplastic or an electrically conductive hot-melt adhesive.

20. Screening cap according to one of Claims 14 to 19, **characterized in that** the screening cap is composed of a metalized insulating material.

## Revendications

1. Procédé pour blinder un circuit (10) électrique ou électronique contre l'absorption et/ou la diffusion d'un rayonnement parasite électromagnétique, procédé selon lequel un couvercle de blindage (14) électriquement conducteur sur une surface de pose (15) est muni d'une garniture d'étanchéité de blindage (16) souple et électriquement conductrice qui dépasse de la surface de pose (15) et ensuite posé avec la garniture d'étanchéité de blindage (16) sur un encadrement (12) électriquement conducteur qui entoure le circuit (10) puis fixé, **caractérisé en ce que** la garniture d'étanchéité de blindage (16) est formée par application directe d'une masse d'étanchéité (21) sur la surface de pose (15), que la masse d'étanchéité (21) est appliquée sur la surface de pose (15) en utilisant une masse d'étanchéité (21) coulante et que le couvercle de blindage (14) muni de la surface de pose (15) est trempé dans un bain de masse d'étanchéité (21) et en est ensuite de nouveau sorti.

2. Procédé selon la revendication 1, **caractérisé en ce que** la masse d'étanchéité utilisée est un élastomère électriquement conducteur.

3. Procédé selon la revendication 2, **caractérisé par** l'utilisation d'un élastomère électriquement conducteur à base de silicone ou de polyuréthane qui contient des matières de remplissage électriquement conductrices.

4. Procédé selon la revendication 1, **caractérisé en ce que** des matières plastiques électriquement conductrices ou isotropes sont utilisées comme masse d'étanchéité.

5. Procédé selon l'une des revendications 1 à 4, **caractérisé en ce que** le couvercle de blindage (14) est fixé mécaniquement après avoir été posé sur l'encadrement (12).

6. Procédé selon la revendication 5, **caractérisé en ce que** la fixation mécanique est réalisée à l'aide d'accessoires (18, 19, 26, 27, 28) qui poussent le couvercle de blindage (14) avec la garniture d'étanchéité de blindage (16) contre l'encadrement (12).

7. Procédé selon la revendication 6, **caractérisé en ce que** les accessoires incluent un étrier de ressort (18).

8. Procédé selon la revendication 6, **caractérisé en ce que** les accessoires incluent une vis (26).

9. Procédé selon la revendication 6, **caractérisé en ce que** les accessoires incluent une partie de boîtier (19) opposée.

10. Procédé selon l'une des revendications 1 à 9, **caractérisé en ce que** le couvercle de blindage (14) adhère par collage avec la garniture d'étanchéité de blindage (16) sur l'encadrement (12) après avoir été posé sur l'encadrement (12).

11. Procédé selon la revendication 10, **caractérisé en ce que** la masse d'étanchéité utilisée est un élastomère électriquement conducteur qui présente une consistance collante ou mouillée.

12. Procédé selon la revendication 11, **caractérisé en ce que** la masse d'étanchéité peut être durcie par exposition à la température ou un rayonnement et elle est durcie après que le couvercle de blindage (14) ait été posé sur l'encadrement (12).

13. Procédé selon la revendication 10, **caractérisé en ce que** la masse d'étanchéité utilisée est un thermoplastique électriquement conducteur ou une colle thermofusible électriquement conductrice et que le couvercle de blindage (14) est collé sur l'encadrement (12) par augmentation de la température après avoir été posé sur l'encadrement (12).

14. Couvercle de blindage (14) pour blinder un circuit (10) électrique ou électronique contre l'absorption et/ou la diffusion d'un rayonnement parasite électromagnétique, couvercle de blindage (14) qui présente une surface de pose (15) pour poser le couvercle de blindage (14) sur un encadrement (12) électriquement conducteur qui entoure le circuit (10), puis est muni sur la surface de pose (15) d'une garniture d'étanchéité de blindage (16) souple et électriquement conductrice qui dépasse de la surface de pose (15), **caractérisé en ce que** la garniture d'étanchéité de blindage (16) est formée sur la surface de pose (15) par immersion à partir d'une masse d'étanchéité (21).

15. Couvercle de blindage selon la revendication 14, **caractérisé en ce que** la surface de pose (15) est réalisée en forme d'arête et que la garniture d'étanchéité de blindage (16) est posée sur le côté frontal de l'arête.

16. Couvercle de blindage selon la revendication 14, **caractérisé en ce que** la surface de pose (15) est réalisée en forme d'arête et que la garniture d'étanchéité de blindage (16) entoure l'arête.

17. Couvercle de blindage selon l'une des revendications 14 à 16, **caractérisé en ce que** la garniture d'étanchéité de blindage (16) se compose d'un élastomère électriquement conducteur, notamment à base de silicone ou de polyuréthane avec des matières de remplissage électriquement conductrices.

18. Couvercle de blindage selon la revendication 17, **caractérisé en ce que** l'élastomère électriquement conducteur présente une consistance collante ou mouillée et peut être durci par exposition à la température ou un rayonnement.

19. Couvercle de blindage selon l'une des revendications 14 à 16, **caractérisé en ce que** la garniture d'étanchéité de blindage (16) se compose d'un thermoplastique électriquement conducteur ou d'une colle thermofusible électriquement conductrice.

20. Couvercle de blindage selon l'une des revendications 14 à 19, **caractérisé en ce qu'**il se compose d'une matière isolante métallisée.
